# EUROPÄISCHE PATENTSCHRIFT

(11) **EP 0 810 425 B1**
(45) Veröffentlichungstag und Bekanntmachung des Hinweises auf die Patenterteilung: **02.04.2003**
(21) Anmeldenummer: 97108563.4
(22) Anmeldetag: 28.05.1997
(51) Int. Cl.: G01K 7/18

(54) **Elektrischer Widerstands-Temperaturfühler**
Electrical resistance temperature sensor
Capteur de température électrique à résistance

(30) Priorität: 30.05.1996 DE 19621689
(43) Veröffentlichungstag der Anmeldung: 03.12.1997
(73) Patentinhaber: E.G.O. ELEKTRO-GERÄTEBAU GmbH, 75038 Oberderdingen (DE)
(72) Erfinder: Bachmann, Volker, 75015 Bretten-Büchig (DE); Ose, Lutz, Dr., 75447 Sternenfels (DE)
(74) Vertreter: Patentanwälte Ruff, Wilhelm, Beier, Dauster & Partner

(56) Entgegenhaltungen:
- EP-A- 0 498 386
- DE-A- 4 330 447
- JP-A- 6 160 332
- JP-A- 58 017 327
- US-A- 5 071 258

## Beschreibung

Die Erfindung betrifft einen elektrischen Widerstands-Temperaturfühler nach dem Oberbegriff des Anspruchs 1, wie er zur Messung der Temperatur an Messobjekten zum Zwecke der Anzeige, Aufzeichnung, Regelung oder Steuerung im Zusammenwirken mit geeigneten Meß- oder Steuergeräten verwendet wird. Insbesondere ist der Temperaturfühler für Einsatz bei hohen Temperaturen bis hin zu 1500 K vorgesehen.

Aus der EP 498 386 B ist ein Temperaturfühler mit einem Mantel aus nicht rostendem Stahl bekannt geworden, in dem in einer pulvrigen, verdichteten, elektrisch isolierenden Einbettmasse ein wendelförmiger Widerstandsdraht liegt. Dieser besteht aus einer Legierung auf Eisenbasis und kann einen positiven Temperatur-Koeffizienten des elektrischen Widerstandes aufweisen, um so eine Temperaturmessung zu ermöglichen. Als Einbettmasse dient ein mineralisches Isoliermaterial wie Magnesiumoxyd (MgO).

Aus der DE 43 30 447 A1 ist ein Temperatur-Sensor bekannt, dessen Wendel zumindest zu einem wesentlichen Teil aus einem Metall der Platin-Gruppe besteht. Dabei ist der Messwiderstand in einem Mantel mit einer mineralisolierenden Füllung enthalten, beispielsweise Magnesiumoxid. Zum Verschließen des Mantels dient hochtemperaturbeständige Vergußmasse, die ein Austreten der mineralisolierenden Füllung verhindert.

Hergestellt wird der Temperaturfühler aus einem mit der Wendel und der Einbettmasse gefülltem Rohr, bei dem danach eine Querschnittsreduzierung des Mantels zur Verpressung der Einbettmasse durchgeführt wird.

### AUFGABE UND LÖSUNG

Aufgabe der Erfindung ist es, einen Temperaturfühler der beschriebenen Art in Bezug auf eine hohe Temperaturbeständigkeit bei möglichst gleichmäßiger Abhängigkeit des Widerstandes von der Temperatur zu verbessern.

Diese Aufgabe wird durch Anspruch 1 gelöst.

Durch die Verwendung eines Edelmetalles, insbesondere von Platin oder einer derartigen Legierung, kann der Temperaturfühler über einen sehr großen Temperaturbereich und auch bei hohen Temperaturen eine weitgehend lineare Kennlinie zwischen Temperatur und Widerstand einhalten. Der Temperaturkoeffizient beträgt dabei mehr als 0,003 [1/K].

Es ist jedoch festgestellt worden, daß beim Einwirken höherer Temperaturen (>550°C), sei es während der Herstellung oder während der Benutzung der meist wendelförmige Platin-Widerstandsdraht sich auflöst oder zersetzt und damit auch seine Widerstandscharakteristik irreversibel ändert. Es wurde gefunden, daß dies darauf zurückzuführen ist, daß das Platin mit der Einbettmasse, die aus Magnesiumoxyd, Aluminiumoxyd etc. bestehen kann, reagiert, insbesondere wenn die Atmosphäre sauerstoffarm ist, was insbesondere bei der Herstellung, beispielsweise Lötvorgängen etc., geschehen kann, die oft unter Vakuum durchgeführt werden und/oder durch die durchaus erwünschte Bildung einer Oxydschicht an der Innenwand des Mantels auftritt.

Es wurde weiter gefunden, daß man diesem begegnen kann, wenn man als Einbettmasse Ceroxid (CeO₂) verwendet. Dies gab jedoch bei Messungen unerwünschte Abweichungen von der Widerstands/Temperaturkurve des Fühlers. Es konnte jedoch erfindungsgemäß festgestellt werden, daß diese Abweichungen von der Temperaturkurve nicht mehr auftreten, wenn der Einbettmasse, die aus einem üblichen hochtemperaturbeständigen Isolier-Schüttmaterial wie Magnesiumoxid oder Aluminiumoxid besteht, nur ein Anteil an Ceroxid beigefügt wird, also eine Mischung von Ceroxid mit anderen Isoliermaterialien verwendet wird.

Versuche haben ergeben, daß das Ceroxid, insbesondere bei kleinen Rohrheizkörperabmessungen und dementsprechend dünnen Isolierschichten zwischen der Widerstandswendel und dem Mantel, bei höheren Temperaturen leitfähig wird. Damit wird durch den Meßströmen überlagerte Ableitströme die Messung verfälscht. Es konnte jedoch gefunden werden, daß dieser Nachteil des Ceroxids nicht auftritt, wenn man es einem anderen Isoliermaterial beimischt, obwohl es seine das Platin schützende Wirkung dann immer noch ausüben kann. Die Wirkung des Ceroxids erklärt sich wahrscheinlich so, daß der Sauerstoff, der bei hohen Temperaturen vom Platin benötigt wird, beim Absinken der Temperatur wieder freigesetzt und dann von Ceroxid wieder aufgenommen wird. Es findet also ein beidseitig reversibler Austausch des Sauerstoffes statt. Die Wirkung des Ceroxids erklärt sich so, daß eine Sauerstoffatmosphäre, die bei hohen Temperaturen benötigt wird, um eine irreversible Reaktion des Platins mit unedlen Bestandteilen des Isoliermateriales zu verhindern, erzeugt wird. Beim Absinken der Temperatur wird Sauerstoff vom Ceroxid wieder aufgenommen, der größtenteils aus der Atmosphäre im Inneren des Sensors kommt.

Es hat sich ergeben, daß schon eine relativ geringe Beimischung ab ca. 1% für die für das Platin schützende Wirkung des Ceroxids, nämlich der Eigenschaft, bei höherer Temperatur reversibel Sauerstoff abzugeben, ausreichen kann. Vorzugsweise werden jedoch 5 bis 35% zweckmäßig sein, wobei besonders günstige Ergebnisse bei 16% Ceroxid im Isoliermaterial gefunden wurden. Dies hängt von den Abmessungen des Temperaturfühlers und den Temperaturbedingungen, sowie von weiteren Vorraussetzungen, wie beispielsweise dem Luftabschluß im Temperaturfühler etc. ab. So kann beispielsweise bei relativ dicken Isolierschichten die Mischung auch einen relativ hohen Prozentsatz von beispielsweise 70% an Ceroxid enthalten.

Ein besonders wichtiges Anwendungsgebiet für den Temperaturfühler ergibt sich bei der Regelung von Abgaskatalysatoren. Dort sind bisher Temperaturmessungen nur punktuell vorgenommen worden, um die dem Katalysator vorausgehenden Vorgänge zu steuern, oder es wurde eine Regelung durch Messung der Abgaszusammensetzung vorgenommen. Mit dem Temperaturfühler nach der Erfindung, der sich mit relativ großer Länge und kleinen Querschnittsabmessungen herstellen läßt, ist es möglich, eine integrale Messung auch bei Abgaskatalysatoren oder ähnlichen Meßobjekten vorzunehmen. So kann beispielsweise ein entsprechend biegsamer Temperaturfühler in das Katalysatormaterial "eingerollt" werden, das meist aus abwechselnden Schichten gewellten und glatten Bleches besteht, die zu einer in Axialrichtung durchströmten Rolle zusammengewickelt sind.

Um dies zu ermöglichen, sollte das Mantelrohr geringe Querschnittsabmessungen von beispielsweise ca. 1 mm Durchmesser aufweisen, die Streckgrenze sollte zwischen 600 N/mm² und 900 N/mm², vorzugsweise bei 700 N/mm² liegen und die Härte des Mantelmateriales sollte 350 Vickers (HV) nicht überschreiten und möglichst bei 180 HV liegen. Dies setzt eine entsprechende Materialwahl voraus, vor allem, da das Material durch die Verformungsvorgänge nach der Rohrfüllung meist sehr hart wird. Das Mantelrohr sollte dementsprechend aus einem FeCrAl-Rohr, und zwar vorzugsweise einem längsnahtgeschweißten gezogenen Rohr bestehen. Es kann auf Eisenbasis 10 bis 25% Chrom und 4 bis 6% Aluminium sowie weitere niederprozentige Legierungsbestandteile wie Yttriom, Mangan, Nickel, Titan und Zink aufweisen.

Der Mantel ist bei einer typischen Ausbildung ein Rohr, so daß ein eigenständiger Temperaturfühler entsteht, der nachträglich mit dem Meßobjekt verbunden wird. Es ist jedoch auch möglich, andere Mantelformen vorzusehen, beispielsweise eine ebenfalls vom Meßobjekt unabhängige Blechtasche, deren doppelter Steg sich ggf. gut für die Anbringung eignet. Ferner ist es möglich, Bauteile des Meßobjektes als Teile des Mantels zu verwenden, indem beispielsweise eines der zur Herstellung eines Abgaskatalysators verwendeten Bleche durch Längs-Aufschweißen eines omega-förmigen Blechprofils den den Widerstandsdraht aufnehmenden Hohlraum bildet. Auch bei einer Ausbildung als Rohr kann der Fühlerquerschnitt von der idealen Kreisform abweichen und beispielsweise oval, D- oder dreiecksförmig sein.

Vorzugsweise sollte bei der Verlegung seiner Anschlüsse, zumindest soweit sie Kontaktstellen zwischen verschiedenen Metallen enthalten, am Meßobjekt darauf geachtet werden, daß sie auf annähernd gleichem Temperaturniveau angeordnet sind, um eine Meßwertverfälschung durch Thermospannungen auszuschließen oder zu minimieren.

Zur Reduzierung des notwendigen Ceroxid-Anteils in der Einbettmasse kann es beitragen, wenn dafür gesorgt wird, daß bei einer während der Herstellung des Meßobjektes, beispielsweise einem Lötvorgang für einen Abgaskatalysator, bei dem der Temperaturfühler mit angelötet wird, der Temperaturfühler druck- bzw. vakuumdicht abgeschlossen ist. So wird es vermieden, daß während dieses unter hoher Temperatur erfolgenden Vorganges der im Temperaturfühlerinneren verbliebene Restsauerstoff herausgesaugt wird, was die vorher beschriebenen Probleme erhöhen würde.

Dies kann durch Zuschweißen des Temperaturfühlers geschehen, wobei dieser dann allerdings in sich kurzgeschlossen ist. Am Ende der Herstellung kann, z.B. durch Durchschneiden einer Verschlußhülse, dieser hermetische Verschluß wieder aufgehoben werden, wodurch gleichzeitig der Temperaturfühler auch wieder elektrisch funktionsfähig wird. Am Austritt eines Anschlußbolzens aus dem Mantel des Temperaturfühlers liegt zwar auch ein Verschluß vor, beispielsweise durch eine Isolationsperle und es wird auch, z.B. durch entsprechende Silikonimprägnierung der Einbettmasse an dieser Stelle, für einen feuchtigkeitsdichten Verschluß gesorgt, jedoch kann hier im Laufe der Zeit Sauerstoff eindringen, was nicht unerwünscht ist.

Der Temperaturfühler kann bevorzugt stabförmig ausgebildet sein. In diesem Falle ist es sinnvoll, die Widerstandsdraht-Wendel von einem aus dem Mantelrohr gegenüber diesem isoliert herausragenden Anschlußbolzen zu einem Anschluß an dem freien Ende des Fühlers zu führen und dort, ebenfalls über einen Anschlußbolzen, mit dem Mantel zu kontaktieren, der den Rückleiter bildet. Es ist jedoch auch möglich, den Widerstandsdraht mit beidseitig isoliert aus dem Mantel herausragenden Anschlußbolzen zu kontaktieren, wobei der Temperaturfühler beispielsweise U- oder haarnadelförmig gebogen sein kann.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischen-Überschriften beschränken die unter diesen gemachten Aussagen nicht in ihrer Allgemeingültigkeit.

### KURZBESCHREIBUNG DER ZEICHNUNGEN

Ausführungsbeispiele der Erfindung sind in den Zeichnungen dargestellt und werden im Folgenden näher erläutert. In den Zeichnungen zeigen:
- Fig. 1: einen abgebrochenen Längsschnitt durch einen Temperaturfühler,
- Fig. 2: einen derartigen Längsschnitt durch eine bezüglich des Anschlusses abgeänderte Variante eines Temperaturfühlers,
- Fig. 3: einen Detail-Querschnitt durch einen Abgaskatalysator mit dem Temperaturfühler,
- Fig. 4: einen Schnitt durch Fig. 3,
- Fig. 5: einen Querschnitt durch einen in das Meßobjekt integrierten Temperaturfühler,
- Fig. 6-8: Varianten der Mantelausführung für einen Temperaturfühler im Querschnitt.

### BESCHREIBUNG VON AUSFÜHRUNGSBEISPIELEN

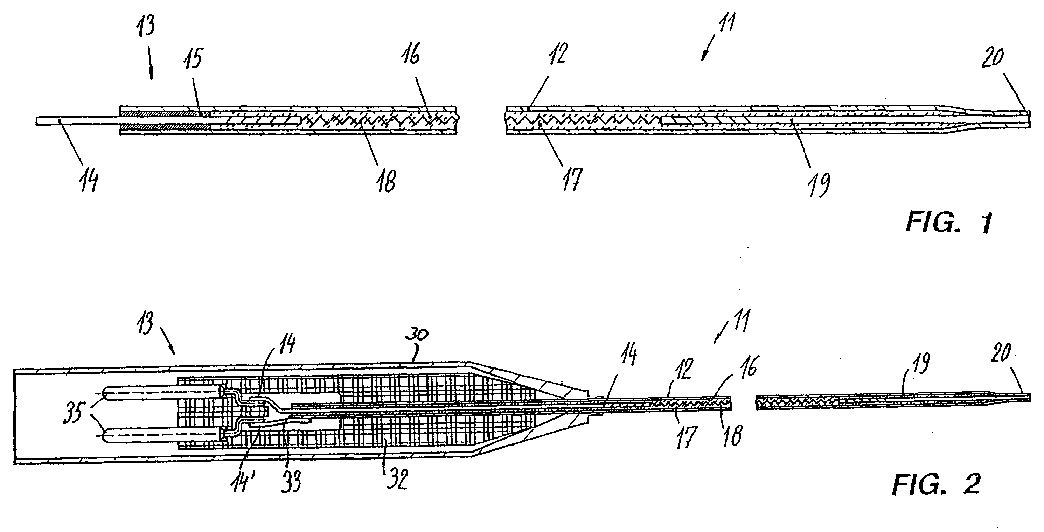

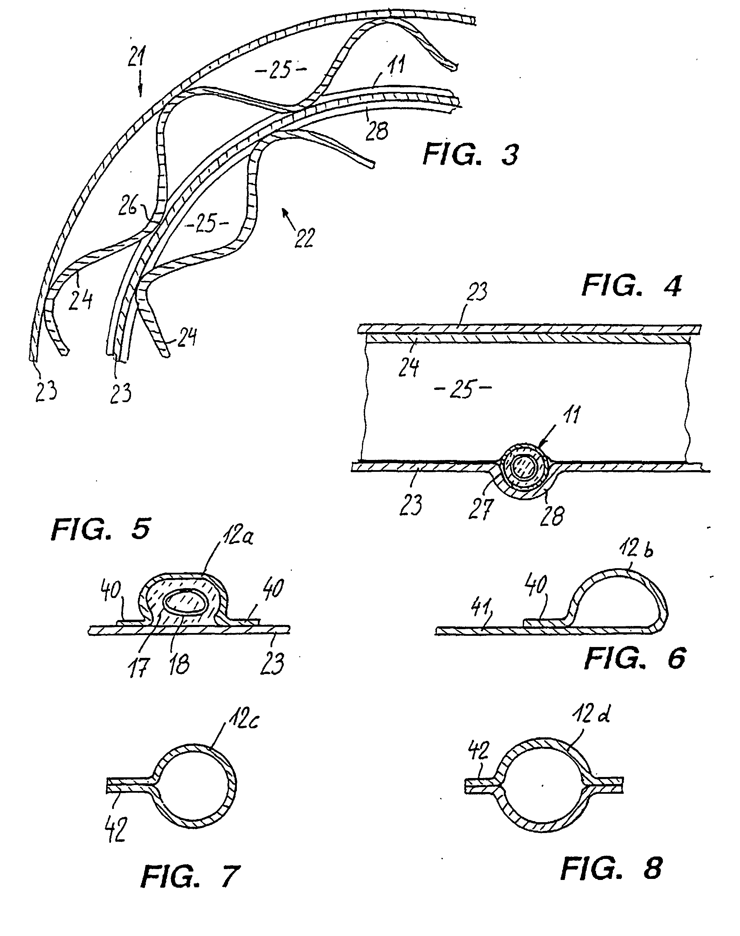

Fig. 1 zeigt einen Temperaturfühler 11 mit einem äußeren, rohrförmigen Mantel 12 aus rostfreien Stahl aus einer Eisen-Chrom-Aluminium-Legierung. Bevorzugt ist eine Legierung, die 20 bis 25% Chrom, 4 bis 6% Aluminium sowie den Rest Eisen und Zusätze von Yttrium, Silicium, Mangan, Nickel, Titan und/oder Zirkon in Konzentrationen von weniger als 1% enthält.

In diesem Rohr, das eine kleinste Querschnittsabmessung, im Falle eines kreisförmigen Rohres: einen Durchmesser, von weniger als 1,5 mm, vorzugsweise bei 1 mm hat, ist im Vergleich dazu sehr lang, nämlich meist wesentlich mehr als 200 mm. Der Mantel 12 ist auf der Anschlußseite 13 offen. Dort ragt ein Anschlußstift oder -bolzen 14 heraus, der vorzugsweise aus dem gleichen Material besteht wie der Mantel 12. Er ist mittels einer Isolierperle 15, d.h. einer den Anschlußbolzen 14 umgebenden Hülse, die passend ins Rohrinnere des Mantels 12 eingesetzt ist, am Anschlußende geführt und abgeschlossen.

Das Innere 16 des Mantels 12 ist mit einer Einbettmasse 17 gefüllt, die aus einer Mischung wenigstens zweier unterschiedlicher Materialien besteht. Ein Material in der Mischung ist ein hochtemperaturbeständiges anorganische elektrisch isolierendes Material wie Magnesiumoxyd, Aluminiumoxyd (MgO, Al₂O₃) o. dgl., das bis zu hohen Temperaturwerten chemisch und physikalisch weitgehend unverändert bleibt und seine elektrische Isolierfähigkeit aufrecht erhält. Dieses Material wird vorzugsweise in Form eines Oxyd-Keramik-Pulvers oder Schüttmaterials mit einer mittleren Korngröße von 2 bis 100 µm (vorzugsweise 24 µm) verwendet.

Als zweite Mischungskomponente wird ein bei höherer Temperatur reversibel sauerstoffabgebendes Material, vorzugsweise Ceroxid in Form eines Pulvers mit der mittleren Korngröße von 2 bis 5 µm verwendet. Das Mischungsverhältnis MgO/CeO₂ beträgt beim Ausführungsbeispiel 6:1 Gewichtsanteile.

In dieser in später noch zu erläuternder Weise verdichteten Einbettmasse liegt mittig eine Platin-Widerstandsdrahtwendel 18, die durch die Einbettmasse 17 von der Innenwand des Mantels 12 elektrisch isoliert ist. Sie ist an dem in das Mantelinnere 16 hineinragenden Ende des Anschlußbolzens 14 elektrisch leitend, beispielsweise durch Schweißung, angebracht. Ihr gegenüberliegendes Ende ist an einem entsprechenden Anschlußbolzen 19 angeschlossen, der relativ lang ist und in ein tüllenartig reduziertes Endstück 20 des Mantels dicht eingeschweißt ist. Es ist auch möglich, die Anschlußbolzen 14, 19 aus dem gleichen Material zu machen wie der Widerstandsdraht, jedoch ist dies wegen der Platinausführung teurer. Die Isolierperle 15 besteht aus Oxydkeramik, beispielsweise Aluminiumoxyd. Die Abdichtung der elektrischen Durchführung an den Anschlußenden aknn bei Bedarf mittels Glaslot oder gelöteten Metall-Keramik-Verbundwerkstoffen erfolgen, jedoch auch mittels Silikonen.

Der Temperaturfühler nach Fig. 1 wird in der gleichen Art hergestellt, wie dies in der EP 498 386 B beschrieben ist, auf die hier ausdrücklich Bezug genommen wird. In ein längsnahtgeschweißtes, gezogenes, vakuumdichtes Edelstahlrohr wird mit einem aus der Herstellung von Rohrheizkörpern bekannten Verfahren die Widerstandsdrahtwendel 18 in die Einbettmasse eingebracht. Die zwar durch Rütteln vorverdichtete, jedoch noch relativ lockere Einbettmasse 17 wird dann dadurch verdichtet, daß das Rohr durch Walzen oder andere Verfahren im Querschnitt reduziert wird. Dabei erfolgt auch gleichzeitig eine Längenausdehnung. Im vorliegenden Falle sind diese Formveränderungen besonders stark, weil die resultierenden Querschnitte sehr gering sind. Durch entsprechende Zwischen-Wärmebehandlung wird jedoch dafür gesorgt, daß die Härte des Mantelmaterialies geringer bleibt als 350 HV, wobei 160 HV als praktische untere Grenze anzusehen ist. Vorzugsweise sollte der Mantel ca. 180 HV haben.

Zusammen mit dem geringen Durchmesser ergibt sich eine gute Biegsamkeit des Temperaturfühlers ohne Beeinträchtigung seiner Funktion. Die aktive Länge des Temperaturfühlers, die jeweils von den inneren Enden der Anschlußstifte begrenzt ist, sollte möglichst groß sein und mindestens 100 mm betragen.

Dadurch ist es möglich, an Meßobjekten, wie beispielsweise einem Abgaskatalysator 21 (Fig. 3) integrierende Messungen vorzunehmen, d.h. Messungen, die einen repräsentativen mittleren Temperaturwert über einen möglichst großen Flächenanteil des Meßobjektes liefern.

Der aktive Kern 22 des Katalysators, der in einem nicht dargestellten rohrförmigen Gehäuse angeordnet ist, besteht aus einem Wickel zweier unterschiedlich gestalteter Blechteile 23, 24, die in ebenfalls nicht dargestellter Weise mit einer platinhaltigen Katalytschicht bedeckt sind. Jeweils ein im wesentlichen glattflächiges Blech 23 und ein gewelltes Blech 24 sind zusammen zu einem zylinderförmigen Kern gerollt, wobei die von dem Wellblech gebildeten Kanäle 25 die Durchtrittskanäle für das senkrecht zur Zeichenebene strömende Abgas aus einem Verbrennungsmotor bilden. Es wird somit eine sehr große aktive Oberfläche für die katalytische Nachverbrennung geschaffen.

In diesen Kern integriert ist der Temperaturfühler 11. Er liegt in einer in das ursprünglich ebene Blech 23 eingeprägten Nut 28 und ist auch geringfügig in die im benachbarten Wellenscheitel 26 des gewellten Bleches 24 hineingedrückt. Der Temperaturfühler 11 ist durch eine Lötung 27, die im Zuge der Gesamtherstellung des Katalysators unter Vakuum vorgenommen wird, gut wärmeleitend mit den Blechen 23, 24 verbunden. Je nach der Länge des Temperaturfühlers kann dieser ein oder mehrere ganze oder Teil-Windungen des Wickels umfassen. Um den Temperaturfühler auch bei einer sowohl in Umfangs- als in Durchmesserrichtung vollintegralen Erfassung nicht zu lang werden zu lassen, könnte der Wickel auch mehrgängig hergestellt werden, indem er aus mehreren Paaren von geraden und gewellten Blechen 23, 24 gebildet wird. Auch andere Anbringungsarten, wie beispielsweise eine diametrale Anordnung quer durch den Wickel, sind möglich.

Der Temperaturfühler wird von einem nicht dargestellten Meßgerät mit einem Meßstrom beschickt. Dabei wird der sich mit der Temperatur im wesentlichen linear ändernde elektrische Widerstand des Widerstandsdrahtes 18 über eine entsprechende Meßschaltung, beispielsweise eine Meßbrücke, gemessen und kann nun zur Anzeige, Aufzeichnung, vor allem aber zur Regelung oder Steuerung eines Prozesses verwendet werden. Im Falle eine Abgaskatalysators für Verbrennungsmotoren wird das Meßergebnis zur elektronischen Motorregelung verwendet, um die Abgaswerte auf ein vorgeschriebenes Minimum zu reduzieren und andererseits auch eine optimale Prozeßtemperatur im Abgaskatalysator herzustellen. Dies gelingt mit dem Temperaturfühler nach der Erfindung besonders gut, weil sein Ausgangssignal die gesamten Temperaturen in seinem aktiven Bereich zwischen den inneren Enden der Anschlußbolzen 14, 19 integral erfaßt und nicht nur punktuell, was zu Fehldeutungen über den Gesamtzustand des Meßobjektes führen könnte.

Fig. 2 zeigt einen Temperaturfühler 11, der dem nach Fig. 1 in allen Einzelheiten und Anwendungsmöglichkeiten gleicht, mit Ausnahme des Anschlußbereiches 13. Über das anschlußseitige Ende des Mantels 12 ist eine Hülse 30, die aus dem gleichen Material wie der Mantel 12 bestehen kann, jedoch mit erheblich größerem Durchmesser und Wandstärke geschoben und durch Löten, Schweißen oder Pressen dicht mit dem Mantel 12 verbunden. Vor dem Aufschieben der Hülse wird das anschlußseitige Ende des Mantels 12 mit den Anschlußbolzen 35 konfektioniert. Hierzu werden die Teile in eine Hälfte eines zweiteiligen Keramikkörpers eingelegt und durch Schweißen mit den Anschlußstiften 14, 14' leitend verbunden. Alternativ kann anstatt des Keramikkörpers eine Vergußmasse zur Anwendung kommen. Auch ist denkbar, die Hülse zum Teil mit Oxidkeramikpulver, beispielsweise dem gleichen Material wie die Einbettmasse 17 zu füllen, das anschließend durch eine Verpressung verfestigt wird.

Fig. 5 zeigt eine Ausführung, bei der der Temperaturfühler in ein Blech 23, das ein Teil des Meßobjektes und insbesondere das ungewellte Blech eines Abgaskatalysators 21 sein kann, integriert ist. Auf dieses Blech sind mittels zweier Längsnahtschweißungen die Seitenflanschen 40 eines omegaförmigen Mantelabschnittes 12a aufgebracht. In dieses ist die Widerstandswendel 18 und die Einbettmasse 17 eingebracht, und zwar entweder in der bereits beschriebenen Weise oder auch durch seitliche Einfüllung bzw. Einlegung in das omegaförmige Mantelteil 12a. Die entsprechende Verdichtung der Einbettmasse kann bereits vor der Aufbringung auf das Blech 23 vorbereitet und ggf. danach noch vervollständigt werden. Bei dieser Ausführung bietet sich besonders eine flachovale Ausführung an, wobei durch die Verpressung auch der Wendelquerschnitt entsprechend dem Mantelquerschnitt verformt wird. Die Wärmeankopplung an das Blech 23 ist optimal und es wird ein gesondertes Mantelrohr 12 eingespart.

Fig. 6 bis 8 zeigen verschiedene Mantelausführungen für den Temperaturfühler. Sie sind in Form von Blechtaschen oder -teilen gebildet. In Fig. 6 ist der Mantel 12b-durch eine D-förmige Ausformung am Rande eines Bleches 41 gebildet, wobei der Flansch 40 mit dem Blech verschweißt ist. Fig. 7 zeigt eine entsprechende Ausbildung, bei der der Mantel 12c aus Blech zu eine Vollkreis gebogen, dann jedoch entlang paralleler, seitlich vorstehender Flansche 42 miteinander verschweißt ist. Fig. 8 zeigt schließlich eine Ausführung, bei der der Mantel 12d aus zwei identischen, omegaförmigen Blechteilen mit halbkreisförmiger Einsenkung zusammengesetzt ist.

## Patentansprüche

1. Elektrischer Widerstands-Temperaturfühler mit einem Mantel (12) aus elektrisch leitfähigem Material und einem darin in elektrisch isolierender, aus verdichtetem Schüttmaterial hergestellter Einbettmasse (17) eingebetteten Widerstandsdrahtes (18), wobei der Widerstandsdraht aus einem Edelmetall mit positivem Temperaturkoeffizienten (PTC-Charakteristik) oder einer Legierung davon besteht und die Einbettmasse (17) ein hochtemperaturbeständiges elektrisch isolierendes Material enthält, **dadurch gekennzeichnet, dass** der Einbettmasse (17) zusätzlich ein bei höherer Temperatur reversibel Sauerstoff abgebendes Material beigerügt ist.

2. Temperaturfühler nach Anspruch 1, **dadurch gekennzeichnet, daß** das Edelmetall ein Metall aus der Gruppe der Platinmetalle ist, vorzugsweise Platin.

3. Temperaturfühler nach Anspruch 1 oder 2, **dadurch gekennzeichnet, daß** das reversibel Sauerstoff abgebende Material Ceroxid (CeO₂) ist.

4. Temperaturfühler nach einem der vorhergehenden Ansprüche, **dadurch gekennzeichnet, daß** das andere elektrisch isolierende Material Magnesiumoxyd oder Aluminiumoxyd ist.

5. Temperaturfühler nach einem der vorhergehenden Ansprüche, **dadurch gekennzeichnet, daß** die Mischung 1 bis 70%, vorzugsweise 5 bis 35% insbesondere ca. 16% Ceroxid enthält.

6. Temperaturfühler nach einem der vorhergehenden Ansprüche, **dadurch gekennzeichnet, daß** die Korngröße des sauerstoffabgebenden Materials 2 bis 5 µm und/oder die des anderen Isoliermaterials 2 bis 100 µm (vorzugsweise ca. 25 µm) beträgt.

7. Temperaturfühler nach einem der vorhergehenden Ansprüche, **dadurch gekennzeichnet, daß** der Mantel (12) aus einem Rohr aus Eisen-Chrom-Aluminium-Legierung, vorzugsweise einem längsnahtgeschweißten, gezogenen Rohr besteht, das insbesondere 20 bis 25% Chrom, 4 bis 6% Aluminium, Rest Eisen, ggf. mit Zusätzen von Yttrium, Selicium, Mangan, Nickel, Titan und/oder Zirkonium in Konzentrationen von jeweils kleiner als 1% enthält.

8. Temperaturfühler nach einem der vorhergehenden Ansprüche, **dadurch gekennzeichnet, daß** der Widerstandsdraht (18) spiralförmig ausgebildet ist.

9. Temperaturfühler nach einem der vorhergehenden Ansprüche, **dadurch gekennzeichnet, daß** der Widerstandsdraht (18) an Anschlußbolzen (14, 19) angebracht ist, die aus dem gleichen Material wie der Widerstandsdraht (18) oder der Mantel (12) besteht, vorzugsweise aus dem gleichen Material wie der Mantel (12).

10. Temperaturfühler nach einem der vorhergehenden Ansprüche, **dadurch gekennzeichnet, daß** der Widerstandsdraht (18) einseitig intern elektrisch an den Mantel (12) angeschlossen ist, vorzugsweise durch dichtes Umfassen und/oder Anschweißen eines Anschlußbolzens (19) durch den Mantel (20).

11. Temperaturfühler nach einem der vorhergehenden Ansprüche, **dadurch gekennzeichnet, daß** eine Anschlußdurchführung in Form einer Keramikperle (15, 36) aus Oxydkeramik, vorzugsweise Aluminiumoxyd, vorgesehen ist.

12. Temperaturfühler nach einem der vorhergehenden Ansprüchen, **dadurch gekennzeichnet, daß** eine Anschlußdurchführung mittels Glaslot oder gelötetem Metall-Keramik-Verbundwerkstoff vorgesehen ist.

13. Temperaturfühler nach einem der vorhergehenden Ansprüche, **dadurch gekennzeichnet, daß** eine Anschlußdurchführung aus einer ggf. gegenüber dem Mantel (12) im Durchmesser größeren Hülse vorzugsweise aus einem dem Mantelmaterial entsprechenden Material vorgesehen ist, das mit dem Mantel (12) dicht verbunden und mit Einbettmasse zumindest teilweise gefüllt ist, die ggf. geringer verdichtet ist als die Einbettmasse (17) im Mantel, wobei vorzugsweise die Hülse (30) während der Herstellung auch nach außen gänzlich verschlossen ist und nachträglich zur Freilegung einer Anschlußfahne (35) teilweise wieder entfernt wird.

14. Temperaturfühler nach einem der vorhergehenden Ansprüche, **dadurch gekennzeichnet, daß** der Mantel (12) ein Rohr mit einem Durchmesser unter 1,5 mm, vorzugsweise bei ca. 1 mm ist, seine Länge über 200 mm, davon die aktive Länge wenigstens 100 mm, beträgt und/oder die Härte des Mantels (12) zwischen 160 und 350 HV, vorzugsweise bei 180 HV und/oder die Streckgrenze zwischen 600 N/mm² und 900 N/mm², vorzugsweise bei 700 N/mm² liegt.

## Claims

1. Electric resistance temperature sensor with an electrically conductive material jacket (12) and a resistance wire (18) located in electrically insulating manner therein embedded in an embedding medium (17) produced from compacted bulk material, the resistance wire comprising a noble metal with a positive temperature coefficient (PTC characteristic) or an alloy thereof and the embedding medium (17) including a high temperature-resistant, electrically insulating material, wherein the embedding medium (17) additionally includes a material reversibly giving off oxygen at higher temperatures.

2. Temperature sensor according to claim 1, wherein the noble metal is a metal from the group of platinum metals, preferably platinum.

3. Temperature sensor according to claim 1 or 2, wherein the reversible oxygen-yielding material is cerium dioxide (CeO₂).

4. Temperature sensor according to one of the preceding claims, wherein the other electrically insulating material is magnesium oxide or aluminium oxide.

5. Temperature sensor according to one of the preceding claims, wherein the mixture contains 1 to 70%, preferably 5 to 35% and in particular approximately 16% cerium dioxide.

6. Temperature sensor according to one of the preceding claims, wherein the particle size of the oxygen-delivering material is 2 to 5 µm and/or the other insulating material is 2 to 100 µm (preferably approximately 25 µm).

7. Temperature sensor according to one of the preceding claims, wherein the jacket (12) comprises a tube of iron-chromium-aluminium alloy, preferably a longitudinally seam welded, drawn tube, which in particular contains 20 to 25% chromium, 4 to 6% aluminium, the remainder iron, optionally with additives of yttrium, silicon, manganese, nickel, titanium and/or zirconium with concentrations of in each case lower than 1%.

8. Temperature sensor according to one of the preceding claims, wherein the resistance wire (18) has a spiral construction.

9. Temperature sensor according to one of the preceding claims, wherein the resistance wire (18) is fitted to joining bolts (14, 19), which are made from the same material as the resistance wire (18) or the jacket (12), preferably from the same material as the jacket (12).

10. Temperature sensor according to one of the preceding claims, wherein the resistance wire (18) is on one side internally electrically connected to the jacket (12), preferably by tight embracing and/or welding of a joining bolt (19) through the jacket (20).

11. Temperature sensor according to one of the preceding claims, wherein there is a connecting passage in the form of a ceramic bead (15, 16) of oxide ceramic, preferably alumina.

12. Temperature sensor according to one of the preceding claims, wherein a connecting passage is provided by means of solder glass or soldered metal-ceramic composite.

13. Temperature sensor according to one of the preceding claims, wherein a connecting passage is provided of a sleeve optionally larger in diameter than the jacket (12) and preferably from a material corresponding to the jacket material, which is tightly connected to the jacket (12) and at least partly filled with embedding medium, which is optionally less compacted than the embedding medium (17) in the jacket and preferably during production the sleeve (30) is completely sealed to the outside and is subsequently partly removed again for exposing a connecting lug (35).

14. Temperature sensor according to one of the preceding claims, wherein the jacket (12) is a tube with a diameter below 1.5 mm, preferably approximately 1 mm, its length is over 200 mm, whereof the active length is at least 100 mm and/or the hardness of the jacket (12) is between 160 and 350 HV, preferably 180 HV and/or the yield strength is between 600 and 900 N/mm², and preferably 700 N/mm².

## Revendications

1. Capteur de température à résistance électrique avec une enveloppe (12) en un matériau électriquement conductible et un fil de résistance (18) incorporé dans celle-ci dans une matière d'enrobage (17) présentant des qualités électriquement isolantes et fabriquée en matériau en vrac comprimé, le fil de résistance étant composé d'un métal précieux présentant un coefficient thermique positif (caractéristique PTC) ou bien d'un alliage de celui-ci et la matière d'enrobage (17) contenant un matériau résistant aux hautes températures électriquement isolant, **caractérisé en ce qu'**on ajoute à la matière d'enrobage (17) un matériau dégageant à des hautes températures de l'oxygène de manière réversible.

2. Capteur de température d'après la revendication 1, **caractérisé en ce que** le métal précieux est un métal du groupe des platinoïdes, de préférence du platine.

3. Capteur de température d'après la revendication 1 ou 2, **caractérisé en ce que** le matériau dégageant de manière réversible de l'oxygène est de l'oxyde de cérium (CeO₂).

4. Capteur de température d'après une des revendications précédentes, **caractérisé en ce que** l'autre matériau électriquement isolant est de l'oxyde de magnésium ou bien de l'oxyde d'aluminium.

5. Capteur de température d'après une des revendications précédentes, **caractérisé en ce que** le mélange contient de 1 à 70%, de préférence de 5 à 35%, notamment à peu près 16% d'oxyde de cérium.

6. Capteur de température d'après une des revendications précédentes, **caractérisé en ce que** la grosseur de grain du matériau dégageant de l'oxygène s'élève à une valeur entre 2 et 5 µm et/ou que celle de l'autre matériau isolant s'élève à une valeur entre 2 et 100 µm (de préférence à peu près de 25 µm).

7. Capteur de température d'après une des revendications précédentes, **caractérisé en ce que** l'enveloppe (12) est constituée d'un tuyau en alliage de fer-chrome-aluminium, de préférence d'un tuyau étiré, soudé en continu en direction longitudinale, contenant notamment de 20 à 25% de chrome, de 4 à 6% d'aluminium, le reste du fer, éventuellement avec des apports d'yttrium, de silicium, de manganèse, de nickel, de titane et/ou de zirconium dans des concentrations au-dessous de 1%.

8. Capteur de température d'après une des revendications précédentes, **caractérisé en ce que** le fil de résistance (18) est réalisé en forme hélicoïdale.

9. Capteur de température d'après une des revendications précédentes, **caractérisé en ce que** le fil de résistance (18) est appliqué à des fiches de connexion (14, 19) composés du même matériau que le fil de résistance (18) ou que l'enveloppe (12), de préférence du même matériau que l'enveloppe (12).

10. Capteur de température d'après une des revendications précédentes, **caractérisé en ce que** le fil de résistance (18) est d'un côté électriquement branché de l'intérieur à l'enveloppe (12), de préférence en enserrant de manière étroite une fiche de connexion (19) et/ou en la joignant par soudage à travers l'enveloppe (20).

11. Capteur de température d'après une des revendications précédentes, **caractérisé en ce qu'**un moyen de traversée est prévu en forme d'une perle isolante céramique (15, 36) en céramique oxydée, de préférence en oxyde d'aluminium.

12. Capteur de température d'après une des revendications précédentes, **caractérisé en ce qu'**un moyen de traversée est prévu au moyen de verre de soudage ou bien au moyen d'un matériau mixte métal-céramique soudé.

13. Capteur de température d'après une des revendications précédentes, **caractérisé en ce qu'**un moyen de traversée est prévu en forme d'une douille éventuellement de diamètre supérieur par rapport à l'enveloppe (12), de préférence en un matériau correspondant au matériau de l'enveloppe, lequel est étroitement joint à l'enveloppe (12) et rempli au moins en partie de matière d'enrobage, laquelle est éventuellement moins comprimée que la matière d'enrobage (17) située dans l'enveloppe, la douille (30) étant de préférence entièrement close aussi vers l'extérieur pendant le processus de fabrication et laquelle est en partie à nouveau supprimée à posteriori pour la mise à nu d'une languette (35).

14. Capteur de température d'après une des revendications précédentes, **caractérisé en ce que** l'enveloppe (12) est un tuyau présentant un diamètre au-dessous de 1,5 mm, de préférence à peu près de 1 mm, la longueur étant au-dessus de 200 mm, la longueur active étant au moins 100 mm et/ou la dureté de l'enveloppe (12) étant située entre 160 et 350 HV, de préférence auprès de 180 HV et/ou la limite d'allongement étant située entre 600 N/mm² et 900 N/mm², de préférence auprès de 700 N/mm².
